(19) Europäisches Patentamt
European Patent Office
Office européen des brevets

(11) **EP 0 545 245 B1**

(12) **EUROPÄISCHE PATENTSCHRIFT**

(45) Veröffentlichungstag und Bekanntmachung des Hinweises auf die Patenterteilung:
**27.03.1996 Patentblatt 1996/13**

(51) Int Cl.⁶: **H03L 7/087**, H03B 27/00

(21) Anmeldenummer: **92120056.4**

(22) Anmeldetag: **25.11.1992**

(54) **Digitaler Oszillator**

Digital oscillator

Oscillateur numérique

(84) Benannte Vertragsstaaten:
**AT CH DE ES FR GB IT LI PT**

(30) Priorität: **05.12.1991 DE 4140132**

(43) Veröffentlichungstag der Anmeldung:
**09.06.1993 Patentblatt 1993/23**

(73) Patentinhaber: **Blaupunkt-Werke GmbH
D-31132 Hildesheim (DE)**

(72) Erfinder:
• **Nyenhuis, Detlev
  W-3220 Sibbesse (DE)**
• **Vogt, Lothar, Dr.
  W-3156 Hohenhameln (DE)**

(56) Entgegenhaltungen:
EP-A- 0 291 826          EP-A- 0 350 663
DE-A- 3 119 448          US-A- 4 285 044
US-A- 4 384 357

## Beschreibung

Gegenstand des Schutzrechtes ist ein neuer steuerbarer digitaler Oszillator, der mit einem digitalen Eingangssignal synchronisierbar ist.

Digitale Oszillatoren werden benötigt, wenn ein trägerfrequentes Signal, das in digitaler Form vorliegt, demoduliert werden soll. Hierbei muß der Oszillator mit der Trägerfrequenz des gesendeten Signals synchronisiert sein.

Aus der DE 31 19 448 A1 ist eine Schaltungsanordnung zur Erzeugung eines cosinusförmigen Signals und eines sinusförmigen Signals bekannt. Die beschriebene Anordnung dient dem Empfang eines modulierten Trägersignals. Phasenmäßige und frequenzmäßige Verschiebungen des übertragenen Signals werden in einer Korrekturstufe KOR korrigiert. Hierzu dient eine Schaltungsanordnung, die sinusförmige und cosinusförmige Signale an die Korrekturstufe abgibt. Das phasenmodulierte Eingangssignal liegt anschließend in reiner Form vor und kann besser ausgewertet werden.

Der Erfinder hat sich die Aufgabe gestellt, einen digitalen Oszillator mit einer Nachsteuerschaltung zu entwickeln, der sich in der Phase mit einem digitalen Eingangssignal synchronisieren läßt und sich durch einen geringen Aufwand auszeichnet.

Die Lösung dieser Aufgabe ist durch die Merkmale des Anspruchs 1 gekennzeichnet.

Die Nachsteuerschaltung läßt sich besonderes einfach aufbauen, wenn vier Abtastwerte des Trägers verfügbar sind. Ein digitaler Oziallator für diesen Anwendungsfall ist durch die Merkmale des Anspruchs 2 gekennzeichnet.

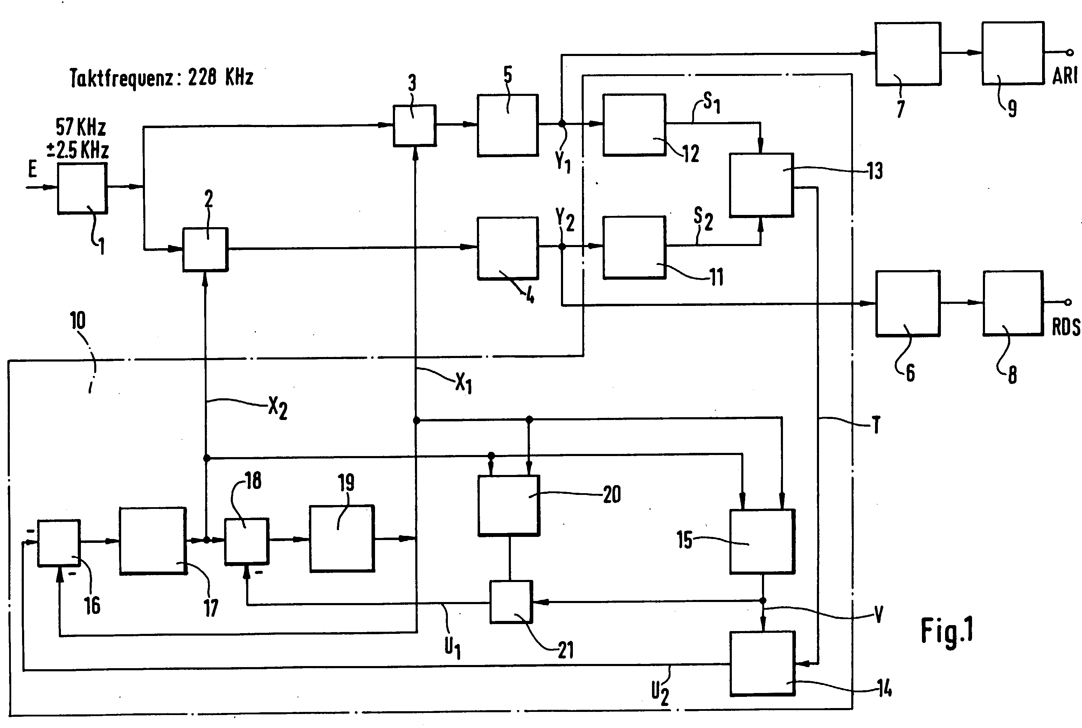

Die Figur 1 zeigt ein Blockschaltbild der Lösung. Mit dieser Schaltung soll die Modulation eines 57-kHz-Hilfsträgers erkannt werden. Der 57-kHz-Hilfsträger wird von den Rundfunksendern zur Übertragung von zwei unabhängigen Informationssystem benutzt, der Verkehrsfunkkennung und dem Radiodatensignal. Dieser modulierte Träger, der im MPX-Signal des empfangenen Rundfunksenders enthalten ist, liegt mit 228 kHZ abgetastet, am Eingang der Schaltung an. Die Abtastwerte werden einem Bandpaß zu zugeführt, dessen Ausgangssignal sich in zwei Teilsignale aufteilt, die jeweils einer zugeordneten Mischstufe 2 bzw. 3 zugeführt werden. An die Ausgänge der Mischstufen schließt sich jeweils ein Tiefpaß 4 bzw. 5 an.

Am Ausgang des Tiefpasses 4 ist nach einem geeigneten Digitalfilter 6 die Auswerteschaltung 8 für das Radiodatensignal, am Ausgang des Tiefpasses 5 hinter einem geeigneten Digitalfilter 7 die Auswerteschaltung 9 für die Verkehrsfunkkennung angeschlossen. Dieser Teil der Beschaltung der Ausgänge der Tiefpässe 4, 5 ist nicht Gegenstand der Erfindung.

Die Erfindung ist vielmehr in der Schaltung 10 realisiert, die ebenfalls an die Ausgänge der beiden Tiefpässe 4 und 5 angeschlossen ist. Diese Schaltung 10 liefert die zweiten Eingangssignale $X_2$ für die Mischstufe 2 und $X_1$ für die Mischstufe 3.

Zur Gewinnung der Eingangssignale $X_1$ und $X_2$ werden die Ausgangssignale $Y_1$, $Y_2$ der Tiefpässe 4 bzw. 5 über Begrenzerstufen 11 bzw. 12 geleitet, an deren Ausgang somit nur die Amplitudenwerte +1 bzw. -1 abgreifbar sind. Die Ausgangssignale $S_1$, $S_2$ der Begrenzerstufen 11 und 12 werden in dem Multiplikator 13 miteinander multipliziert, so daß an dessen Ausgang während der einzelnen Takteinheiten der 228-kHz-Abtastfrequenz das Signal T entweder den Wert +1 oder -1 annimmt.

In einem Kurzzeitintegrator 14 werden diese Werte während einer vorgebbaren Anzahl von Takten aufsummiert. Nur wenn der Summenwert einen vorgegebenen ersten Bezugswert +A über- oder -A unterschreitet, wird zur Phasenregelung ein Wert (Phaseninkrement) $U_2$ bzw. $-U_2$ zu einer ersten Addierstufe 16 freigegeben, sofern zuvor ein Vergleicher 15 erkannt hat, daß in der Takteinheit, in der der Summenwert abgefragt wird, die Amplitude des Signals $X_2$ größer (oder gleich) ist als der Betrag der Amplitude des Signals $X_1$.

Das Ausgangssignal der Addierstufe 16 wird in einer Verzögerungsstufe 17 um eine Takteinheit verzögert. Deren Ausgangssignal bildet das Eingangssignal $X_2$ für die Mischstufe 2.

Das Signal $X_2$ wird zugleich dem bereits erwähnten Vergleicher 15 zugeleitet.

Zur Amplitudenregelung wird das Signal $X_2$ einer zweiten Addierstufe 18 zugeführt. In dieser Addierstufe 18 wird dem Eingangssignal $X_2$ in jeder Takteinheit ein vorgegebener kleiner Wert $U_1$ hinzugefügt bzw. abgezogen, wenn einerseits die Schaltung 20 feststellt, daß die Summe der Quadrate der Amplituden der Eingangssignale $X_1$ und $X_2$ kleiner als ein voreingestellter Bezugswert (1-a) bzw. größer als der Bezugswert (1+a) ist, wobei a eine wählbare Größe zwischen 0 und 1 ist und andererseits der Vergleicher 15 das Undtor 21 freigegeben hat.

Der Ausgangswert der Addierstufe 18 wird erneut um eine Takteinheit, d. h. um 90° in der Phase, verzögert. Das Ausgangssignal dieser Verzögerungsstufe 19 bildet das zweite Eingangssignal $X_1$ für die Mischstufe 3.

Dieses Signal $X_1$ wird ebenfalls der Vergleichsstufe 15, aber auch ebenso wie das Eingangssignal $X_2$ der Schaltung 20, zur Bildung der Summe der Amplitudenquadrate zugeführt.

Außerdem bildet das Signal $X_1$ die zweite Eingangsgröße für die erste Addierstufe 16.

Demnach wird schrittweise in der Addierstufe 16 das Eingangssignal von Zeit zu Zeit vergrößert oder verkleinert, solange bis der Phasenfehler zwischen Oszillatorausgangssignal und -eingangssignal verschwindet.

Durch diese Regelung vergrößert oder verkleinert sich der Betrag der Oszillatorausgangssignale $X_1$ und $X_2$. Dieser

Amplitudenfehler wird durch die Schaltung 20 kompensiert.

Beide Regelungen (Phasenregelung und Amplitudenregelung) sind nur aktiv, wenn die Vergleichsstufe 15 den aus-gewählten Regelbereich ($X_2 \geq X_1$) erkannt hat.

Die erfindungsgemäße Gesamtschaltung läßt sich auch durch die auf den folgenden Seiten angegebenen Glei-chungen beschreiben.

Gleichungen

ARI:       $\alpha = 1 + \text{mod} \sin (2\pi\, I)$

           mod = Modulationsgrad

           I = Bereichs-, Durchsagekennung

RDS:       r

Abtastzyklus-Nr.:       K

$E(K)$:       $\alpha \cdot \sin(\frac{\pi}{2} \cdot K) + r \cdot \cos(\frac{\pi}{2} \cdot K)$

$X_1$:       $\sin(\frac{\pi}{2} \cdot K + \Theta)$       $\Theta$ = Phasenfehler

$X_2$:       $\cos(\frac{\pi}{2} \cdot K + \Theta)$

$Y_1$:       $\sim \frac{1}{2}(\alpha \cos \Theta + r \sin \Theta)$

$Y_2$:       $\sim \frac{1}{2}(-\alpha \sin \Theta + r \cos \Theta)$

$S_1(K)$:       -1 falls $Y_1 < 0$

           :       +1 falls $Y_1 \geq 0$

$S_2(K)$:       1 falls $Y_2 \geq 0$

           :       -1 falls $Y_2 < 0$

$$T(K): \begin{array}{l} +1 \\ : \quad -1 \end{array} \Big\} = S_1(K) \cdot S_2(K)$$

$V$:       +1 falls $X_2 \geq X_1$

           :       0 sonst

$U_1(K) : = > 0$       = const       falls $X_2^2 + X_2^2 \leq 1 - a$

           = -const       falls $X_2^2 + X_2^2 > 1 + a$

$U_2(mK): = > 0$       = const       falls $\Sigma$ der $T(K)$ während m Takteinheiten $\geq A$

           = -const       falls $\Sigma$ der $T(K)$ während m Takteinheiten $\leq -A$

           = 0 sonst

Legende

E.       Eingangssignal, digitales MPX-Signal eines Rundfunksenders, Abtastfrequenz 228 kHz.

1       Bandpaß, abgestimmt auf 57 kHz ±2,5 kHz

2, 3, 13       Multiplizierer

4, 5       Tiefpässe

| 6, 7 | Digitale Filter |
| 8 | Auswerteschaltung für Radiodatensignale |
| 9 | Auswerteschaltung für Verkehrsfunkkennungen |
| 11, 12 | Begrenzer |
| 14 | Kurzzeitintegrator |
| 15 | Vergleicher $X_2 \geq X_1$ |
| 16, 18 | Addierstufen |
| 17, 19 | Verzögerungsglieder |
| 20 | Summierstufe von $X_1{}^2 + X_2{}^2$ |
| 21 | Torschaltung |

## Patentansprüche

1. Steuerbarer, digitaler Oszillator, der mit einem digitalen Eingangssignal synchronisierbar ist, dadurch gekennzeichnet, daß zur Synchronisation das Oszillatorausgangssignal in zwei Komponenten aufgesplittet wird, wobei die zweite Komponente gegenüber der ersten Komponente um 90° phasenverschoben ist, daß Mittel vorhanden sind, die in Abhängigkeit von dem Vorzeichen der Phasendifferenz zwischen dem digitalen Eingangssignal (E) und dem Oszillatorausgangssignal den Momentanwert der ersten Komponente (X1) iterativ vergrößern oder verkleinern und die dadurch entstehende Veränderung in der Amplitude des Ausgangssignals durch iterative Verkleinerung bzw. Vergrößerung des Momentanwertes der zweiten Komponente (X2) kompensieren, wenn die Summe der Quadrate der Momentanwerte der beiden Komponenten (X1, X2) einen vorgegeben Betrag (1+a) bzw. (1-a) über- bzw. unterschreitet.

2. Ozillator nach Anspruch 1, gekennzeichnet durch, die Hintereinanderschaltung einer ersten Addierstufe (16), einer ersten Verzögerungsstufe (17), einer zweiten Addierstufe (18) und einer zweiten Verzögerungsstufe (19), durch eine Rückkoppelschleife vom Ausgang der zweiten Verzögerungsstufe (19) zu einem ersten Eingang der ersten Addierstufe (16) und durch eine Steuerschaltung (14,15,20,21) deren erster Ausgang (U2) mit dem zweiten Eingang der ersten Addierstufe (16) und deren zweiter Ausgang (U1) mit dem zweiten Eingang der zweiten Addierstufe (18) verbunden ist und von deren Eingängen einer an den Ausgang der ersten Verzögerungsstufe (17) und ein zweiter an den Ausgang der zweiten Verzögerungsstufe (19) angeschlossen ist, während einem dritten das ein der Phasendifferenz zwischen dem digitalen Eingangssignal und dem Oszillatorsignal entsprechende Signal zugeführt ist, wobei die Steuerschaltung in Abhängigkeit von dem Vorzeichen der Phasendifferenz in der ersten Addierstufe (16) dessen Eingangssignal iterativ vergrößert oder verkleinert und in Abhängigkeit von der Veränderung dieses Signals das Eingangssignal der zweiren Addierstufe (18) iterativ derart vergrößert oder verkleinert, daß das Quadrat des Betrages der vekturiell addierten Ausgangssignale bei der Verzögerungsstufen einen vorgegebenen Wert (1+a) bzw. (1-a) nicht über- bzw. unterschreitet.

## Revendications

1. Oscillateur numérique commandé, synchronisé par un signal d'entrée numérique, caractérisé en ce que pour synchroniser le signal de sortie de l'oscillateur on le divise en deux composantes, la seconde composante étant déphasée de 90° par rapport à la première composante, des moyens étant prévus pour qu'en fonction du signal algébrique de la différence de phase entre le signal d'entrée numérique (E) et le signal de sortie de l'oscillateur, la valeur instantanée de la première composante ($x_1$) soit augmentée ou diminuée de manière itérative et que la variation qui en résulte en amplitude du signal de sortie soit compensée par la réduction de l'augmentation itérative de la valeur instantanée de la seconde composante ($x_2$) si la somme des carrés des valeurs instantanées des deux composantes ($x_1$, $x_2$) dépasse vers le haut ou vers le bas, une valeur prédéterminée (1+a) ou (1-a).

2. Oscillateur selon la revendication 1, caractérisé par le montage en série d'un premier additionneur (16), d'un premier étage de retard (17), d'un second additionneur (18) et d'un second étage de retard (19), par une boucle de réaction entre la sortie du second étage de retard (19) et une première entrée du premier additionneur (16) et par un circuit de commande (14, 15, 20, 21) dont la première sortie ($U_2$) est reliée à la seconde entrée du premier additionneur (16) et dont la seconde sortie ($U_1$) est reliée à la seconde entrée du second additionneur (18) et dont l'une des entrées est reliée à la sortie du premier étage retardateur (17) et la seconde entrée à la sortie du second étage retardateur (19) alors qu'une troisième entrée reçoit un signal correspondant à la différence de phase entre le signal d'entrée numérique et le signal de l'oscillateur, le circuit de commande est lu en fonction du signal algébrique de la différence de phase dans le premier additionneur (16) dont le signal d'entrée est augmenté ou diminué de manière itérative et en fonction de la variation de ce signal, le signal d'entrée du second additionneur (18) est augmenté ou diminué de manière itérative pour que le carré de la valeur du signal de sortie d'addition vectorielle des étages de retard ne dépasse ni vers le haut ni vers le bas une valeur prédéterminée (1+a) ou (1-a).

**Claims**

1. Controllable, digital oscillator which can be synchronized with a digital input signal, characterized in that for the purpose of synchronization the oscillator output signal is split into two components, the second component being phase-shifted with respect to the first component by 90°, in that means are present which, as a function of the sign of the phase difference between the digital input signal (E) and the oscillator output signal, iteratively increase or decrease the instantaneous value of the first component (X1), and which compensate for the change produced thereby in the amplitude of the output signal by iteratively decreasing or increasing the instantaneous value of the second component (X2) when the sum of the squares of the instantaneous values of the two components (X1, X2) overshoots or undershoots a prescribed absolute value (1+a) or (1-a), respectively.

2. Oscillator according to Claim 1, characterized by the series connection of a first adder stage (16), a first time-delay stage (17), a second adder stage (18) and a second time-delay stage (19), by a feedback loop from the output of the second time-delay stage (19) to a first input of the first adder stage (16) and by a control circuit (14, 15, 20, 21) whose first output (U2) is connected to the second input of the first adder stage (16) and whose second output (U1) is connected to the second input of the second adder stage (18) and of whose inputs one is connected to the output of the first time-delay stage (17) and a second is connected to the output of the second time-delay stage (19), while a third is fed the signal corresponding to the phase difference between the digital input signal and the oscillator signal, it being the case that, as a function of the sign of the phase difference in the first adder stage (16), the control circuit iteratively increases or decreases the input signal thereof and, as a function of the change in said signal, iteratively increases or decreases the input signal of the second adder stage (18) in such a way that, in the time-delay stages, the square of the absolute value of the vectorially added output signals does not overshoot or undershoot a prescribed value (1+a) or (1-a), respectively.

Taktfrequenz: 228 KHz

Fig.1

EP 0 545 245 B1

6